# EUROPEAN PATENT APPLICATION

(11) **EP 4 692 212 A1**
(43) Date of publication of application: **11.02.2026**
(21) Application number: 25775107.3
(22) Date of filing: 27.03.2025
(51) Int. Cl.: C08L 23/16, C08K 5/14, C08K 5/36, C08L 23/06, C08L 23/22, C09K 3/10, F16J 15/10, F16L 9/127, F16L 11/06, H01L 23/02

(54) **RUBBER MEMBER, AND SEMICONDUCTOR MANUFACTURING?RELATED DEVICE**

(30) Priority: 28.03.2024 JP 2024053731; 03.10.2024 JP 2024174288
(71) Applicant: Daikin Industries, Ltd., Osaka-shi, Osaka 530-0001 (JP)
(72) Inventor: OKUNO, Shingo, Osaka-Shi, Osaka 530-0001 (JP); TANAKA, Yuhei, Osaka-Shi, Osaka 530-0001 (JP)
(74) Representative: Hoffmann Eitle
(86) International application number: PCT/JP2025/012510
(87) International publication number: WO 2025/206198

(57) **Abstract**

The disclosure provides a rubber member excellent in corrosion resistance and a semiconductor manufacturing-related apparatus using the rubber member. Provided is a rubber member containing an olefin-based rubber. The rubber member includes at least one selected from the group consisting of an architectural finishing material member, a mobility member, an aerospace member, a semiconductor member, and an information and communication member. The rubber member comes into contact with a corrosive substance.

## Description

### TECHNICAL FIELD

The disclosure relates to rubber members and semiconductor manufacturing-related apparatuses.

### BACKGROUND ART

Use of a mixture of a certain resin and rubber for packings in sealed-type batteries has been proposed (see Patent Literature 1, for example).

### CITATION LIST

### - Patent Literature

Patent Literature 1: JP 2008-7671 A

### SUMMARY OF INVENTION

### - Technical Problem

The disclosure aims to provide a rubber member excellent in corrosion resistance and a semiconductor manufacturing-related apparatus using the rubber member.

### - Solution to Problem

The disclosure (1) relates to a rubber member containing an olefin-based rubber,
the rubber member including at least one selected from the group consisting of an architectural finishing material member, a mobility member, an aerospace member, a semiconductor member, and an information and communication member,
the rubber member coming into contact with a corrosive substance.

The disclosure (2) relates to the rubber member according to the disclosure (1), wherein the olefin-based rubber includes at least one selected from the group consisting of ethylene-propylene-diene rubber, ethylene-propylene rubber, and butyl rubber.

The disclosure (3) relates to the rubber member according to the disclosure (2), wherein the ethylene-propylene-diene rubber and the ethylene-propylene rubber each have an ethylene content of 50 to 70% by mass.

The disclosure (4) relates to the rubber member according to any one of the disclosures (1) to (3), wherein the olefin-based rubber has a diene monomer content of 0 to 5% by mass.

The disclosure (5) relates to the rubber member according to any one of the disclosures (1) to (4), wherein the olefin-based rubber has a Mooney viscosity (ML₁₊₄ (100°C)) of 10 to 200.

The disclosure (6) relates to the rubber member according to any one of the disclosures (1) to (5), wherein the rubber member contains an olefin resin in an amount of 1 to 60% by mass based on the olefin-based rubber.

The disclosure (7) relates to the rubber member according to any one of the disclosures (1) to (5), wherein the rubber member contains an olefin resin in an amount of 45 to 55% by mass based on the olefin-based rubber.

The disclosure (8) relates to the rubber member according to the disclosure (6) or (7), wherein the olefin resin is a polyethylene resin.

The disclosure (9) relates to the rubber member according to any one of the disclosures (6) to (8), wherein the olefin resin includes at least one selected from the group consisting of high-density polyethylene having a density of 0.94 to 0.97 g/m³ and ultra high molecular weight polyethylene having a weight average molecular weight of 1.0 × 10⁶ to 1.0 × 10⁷.

The disclosure (10) relates to the rubber member according to any one of the disclosures (1) to (9), wherein the olefin-based rubber is crosslinked using at least one of a peroxide crosslinking agent or a sulfur-based crosslinking agent.

The disclosure (11) relates to the rubber member according to any one of the disclosures (1) to (10), wherein the rubber member includes at least one selected from the group consisting of a container, a piping material, a nozzle, a tube, a tank, a fitting, a valve, a pump, a spin chuck, an O-ring, a packing, a gasket, a washer, and a sealing material.

The disclosure (12) relates to the rubber member according to any one of the disclosures (1) to (11), wherein the corrosive substance has a pH of 6 or lower or 8 or higher.

The disclosure (13) relates to the rubber member according to any one of the disclosures (1) to (12), wherein the corrosive substance has a redox potential (vs. NHE) of -2.0 to 3.0 V.

The disclosure (14) relates to the rubber member according to any one of the disclosures (1) to (13), wherein the corrosive substance includes at least one selected from the group consisting of an acidic substance, a basic substance, an oxidizing substance, an organic solvent, and salt water.

The disclosure (15) relates to the rubber member according to the disclosure (14), wherein the acidic substance includes at least one selected from the group consisting of sulfuric acid, hydrofluoric acid, nitric acid, phosphoric acid, hydrochloric acid, a mixed acid of hydrofluoric acid and nitric acid, a mixed chemical solution of hydrogen peroxide water and hydrochloric acid, and a mixed chemical solution of hydrogen peroxide water and sulfuric acid.

The disclosure (16) relates to the rubber member according to the disclosure (14) or (15), wherein the basic substance includes at least one selected from the group consisting of TMAH ([(CH₃)₄N]⁺[OH]⁻), an aqueous sodium hydroxide solution, ammonia water, and a mixed chemical solution of hydrogen peroxide water and ammonia water.

The disclosure (17) relates to the rubber member according to any one of the disclosures (1) to (16), wherein the corrosive substance includes at least one selected from the group consisting of hydrofluoric acid, nitric acid, phosphoric acid, hydrochloric acid, a mixed acid of hydrofluoric acid and nitric acid, a mixed chemical solution of hydrogen peroxide water and hydrochloric acid, a mixed chemical solution of hydrogen peroxide water and sulfuric acid, TMAH ([(CH₃)₄N]⁺[OH]⁻), an aqueous sodium hydroxide solution, a mixed chemical solution of hydrogen peroxide water and ammonia water, and isopropyl alcohol.

The disclosure (18) relates to the rubber member according to any one of the disclosures (1) to (17), wherein the rubber member is for a semiconductor manufacturing-related apparatus.

The disclosure (19) relates to the rubber member according to the disclosure (18), wherein the semiconductor manufacturing-related apparatus is an apparatus in which a chemical is used.

The disclosure (20) relates to the rubber member according to any one of the disclosures (1) to (19), wherein when a test piece (size: 10 mm × 50 mm × 2 mm) including the rubber member is immersed in each of the following four chemical solutions for one week, a relative value of a mass of the test piece after the immersion, with a mass before the immersion taken as 100, is 50 or more and 150 or less for all the four chemical solutions:
(chemical solutions)
25% by mass TMAH ([(CH₃)₄N]⁺[OH]⁻) (80°C);
49% by mass hydrofluoric acid (70°C);
a mixed acid of hydrofluoric acid and nitric acid (a mixture of 49% by mass hydrofluoric acid and 69 to 71% by mass nitric acid in a volume ratio of 1:100) (20°C); and
SPM (a mixture of 98% by mass sulfuric acid and 30 to 36% by mass hydrogen peroxide water in a volume ratio of 2:1) (80°C).

The disclosure (21) relates to the rubber member according to any one of the disclosures (1) to (20), wherein when a test piece (size: 10 mm × 50 mm × 2 mm) including the rubber member is immersed in each of the following nine chemical solutions for one week and a relative value of a mass of the test piece after the immersion, with a mass before the immersion taken as 100, is measured for each chemical solution, an average of the relative values for the nine chemical solutions is 80 or more and 120 or less, and a standard deviation thereof is 20 or less:
(chemical solutions)
25% by mass TMAH ([(CH₃)₄N]⁺[OH]⁻) (80°C);
100% by mass isopropyl alcohol (80°C);
49% by mass hydrofluoric acid (70°C);
a mixed acid of hydrofluoric acid and nitric acid (a mixture of 49% by mass hydrofluoric acid and 69 to 71% by mass nitric acid in a volume ratio of 1:5) (20°C);
a mixed acid of hydrofluoric acid and nitric acid (a mixture of 49% by mass hydrofluoric acid and 69 to 71% by mass nitric acid in a volume ratio of 1:100) (20°C);
SPM (a mixture of 98% by mass sulfuric acid and 30 to 36% by mass hydrogen peroxide water in a volume ratio of 2:1) (80°C);
SC1 (a mixture of 25 to 28% by mass ammonia water, 30 to 36% by mass hydrogen peroxide water, and deionized water in a volume ratio of 1:1:5) (70°C);
SC2 (a mixture of 35 to 37% by mass hydrochloric acid, 30 to 36% by mass hydrogen peroxide water, and deionized water in a volume ratio of 1:1:4) (70°C); and
85% by mass phosphoric acid (80°C).

The disclosure (22) relates to the rubber member according to any one of the disclosures (1) to (21), wherein when a test piece (size: 10 mm × 50 mm × 2 mm) including the rubber member is immersed in 3.6% by mass hydrochloric acid at 23°C for one week, an elution amount of each of 15 metal elements (Li, Na, Mg, Al, K, Ca, Ti, Cr, Mn, Fe, Ni, Cu, Ag, Cd, and Pb) is 30 ppb or less.

The disclosure (23) relates to the rubber member according to any one of the disclosures (1) to (22), wherein when a test piece (size: 10 mm × 50 mm × 2 mm) including the rubber member is immersed in 3.6% by mass hydrochloric acid at 23°C for one week, an elution amount of Zn is 150 ppb or less.

The disclosure (24) relates to the rubber member according to any one of the disclosures (1) to (23), wherein when a test piece (size: 10 mm × 50 mm × 2 mm) including the rubber member is immersed in 3.6% by mass hydrochloric acid at 23°C for one week, an elution amount of each of 16 metal elements (Li, Na, Mg, Al, K, Ca, Ti, Cr, Mn, Fe, Ni, Cu, Zn, Ag, Cd, and Pb) is 150 ppb or less.

The disclosure (25) relates to a semiconductor manufacturing-related apparatus including the rubber member according to any one of the disclosures (1) to (24) mounted thereon.

The disclosure (26) relates to the semiconductor manufacturing-related apparatus according to the disclosure (25), which includes at least one selected from the group consisting of a semiconductor manufacturing apparatus and a semiconductor manufacturing apparatus-related apparatus.

The disclosure (27) relates to the semiconductor manufacturing-related apparatus according to the disclosure (26), wherein the semiconductor manufacturing apparatus includes at least one selected from the group consisting of a photolithography process apparatus, a thin film formation/etching/cleaning/drying apparatus, an inspection/evaluation and manufacturing apparatus, a resist processing apparatus, an etching apparatus, a cleaning/drying apparatus, a CVD apparatus, a thin film formation apparatus, a CMP apparatus, a processing apparatus, an aging apparatus, and an inspection apparatus; and
the semiconductor manufacturing apparatus-related apparatus includes at least one selected from the group consisting of a pure water/chemical liquid apparatus, a gas apparatus, a clean room apparatus, and a manufacturing-related apparatus.

The disclosure (28) relates to the semiconductor manufacturing-related apparatus according to the disclosure (27), wherein the photolithography process apparatus includes at least one selected from the group consisting of a coating apparatus, a resist stripping apparatus, a developing apparatus (developer), and a descumming apparatus;
the thin film formation/etching/cleaning/drying apparatus includes at least one selected from the group consisting of a vacuum deposition apparatus, a cleaning apparatus, a drying apparatus, and a scrub cleaning apparatus;
the inspection/evaluation and manufacturing apparatus is a defect repair apparatus,
the resist processing apparatus includes at least one selected from the group consisting of a coating apparatus, a developing apparatus, a resist stripping apparatus, and an ashing apparatus;
the etching apparatus includes at least one selected from the group consisting of a dry etching apparatus and a wet etching apparatus;
the cleaning/drying apparatus includes at least one selected from the group consisting of a wet cleaning apparatus, a scrub cleaning apparatus, and a drying apparatus;
the CVD apparatus includes at least one selected from the group consisting of a high-pressure CVD apparatus, a SACVD apparatus, a low-pressure CVD apparatus, a plasma CVD apparatus, a metal CVD apparatus, and an ALD apparatus;
the thin film formation apparatus includes at least one selected from the group consisting of a vacuum deposition apparatus, a silicon epitaxial growth apparatus, a compound semiconductor epitaxial apparatus (MOCVD apparatus, MBE apparatus), and a plating apparatus;
the CMP apparatus includes at least one selected from the group consisting of a CMP apparatus and a CMP cleaning apparatus;
the processing apparatus is a bump plating apparatus;
the aging apparatus includes at least one selected from the group consisting of an aging apparatus, a burn-in apparatus, an IC insertion apparatus, and an IC extraction apparatus;
the inspection apparatus is a life test apparatus,
the pure water/chemical liquid apparatus includes at least one selected from the group consisting of a chemical supply apparatus, a slurry supply apparatus, a chemical purification apparatus, and a waste liquid treatment apparatus;
the gas apparatus includes at least one selected from the group consisting of a gas generation apparatus, a gas purification apparatus, a gas mixing apparatus, a gas detection apparatus, and an exhaust gas treatment apparatus;
the clean room apparatus includes at least one selected from the group consisting of a thermal chamber and an environmental test apparatus; and
the manufacturing-related apparatus includes at least one selected from the group consisting of a jig cleaning/drying apparatus, a flow control instrument, a packaging apparatus, and a liquid/gas measuring instrument.

### - Advantageous Effects of Invention

The disclosure can provide a rubber member excellent in corrosion resistance and a semiconductor manufacturing-related apparatus using the rubber member.

### DESCRIPTION OF EMBODIMENTS

The disclosure is described in detail below.

The disclosure relates to a rubber member containing an olefin-based rubber. The rubber member includes at least one selected from the group consisting of an architectural finishing material member, a mobility member, an aerospace member, a semiconductor member, and an information and communication member. The rubber member comes into contact with a corrosive substance.

The rubber member of the disclosure has excellent corrosion resistance (in particular, excellent chemical resistance).

The rubber member of the disclosure is also excellent in compression set properties and can reduce or prevent metal elution.

The rubber member of the disclosure contains an olefin-based rubber. The olefin-based rubber refers to rubber containing an olefin-derived structural unit as a main structural unit.

Examples of the olefin-based rubber include ethylene-α-olefin-non-conjugated diene rubbers such as ethylene-propylene-diene rubber (EPDM); ethylene-α-olefin rubbers such as ethylene-propylene rubber (EPM); butyl rubber (IIR); isoprene rubber (IR); cyclopentene rubber (CR); butadiene rubber (BR); natural rubber (NR); and styrene butadiene rubber (SBR). One or two or more of these can be used.

In order to further improve the corrosion resistance and the compression set properties and to further reduce or prevent metal elution, the olefin-based rubber preferably includes at least one selected from the group consisting of ethylene-α-olefin-non-conjugated diene rubbers, ethylene-α-olefin rubbers, and butyl rubber, more preferably includes at least one selected from the group consisting of ethylene-α-olefin-non-conjugated diene rubbers and ethylene-α-olefin rubbers, still more preferably includes an ethylene-α-olefin rubber.

From the same viewpoint, the olefin-based rubber preferably includes at least one selected from the group consisting of ethylene-propylene-diene rubber, ethylene-propylene rubber, and butyl rubber, more preferably includes at least one selected from the group consisting of ethylene-propylene-diene rubber and ethylene-propylene rubber, still more preferably includes ethylene-propylene rubber.

Examples of the α-olefin include propylene, 1-butene, 1-pentene, 1-hexene, 1-heptene, 1-octene, 1-nonene, and 1-decene. One or two or more of these can be used. Preferred among these are propylene, 1-butene, and 1-hexene.

Examples of the non-conjugated diene include: linear non-conjugated dienes such as 1,4-hexadiene, 1,6-octadiene, 2-methyl-1,5-hexadiene, 6-methyl-1,5-heptadiene, and 7-methyl-1,6-octadiene; cyclic non-conjugated dienes such as dicyclopentadiene, vinyl cyclohexene, cyclohexadiene, methyl tetrahydroindene, 5-vinyl norbornene, 5-ethylidene-2-norbornene, 5-methylene-2-norbornene, 5-isopropylidene-2-norbornene, and 6-chloromethyl-5-isopropenyl-2-norbonene; and trienes such as 2,3-diisopropylidene-5-norbornene, 2-ethylidene-3-isopropylidene-5-norbornene, 2-propenyl-2,2-norbomadiene, 1,3,7-octatriene, and 1,4,9-decatriene. One or two or more of these can be used. Preferred among these are cyclic non-conjugated dienes and 1,4-hexadiene.

In order to further improve the corrosion resistance and the compression set properties and to further reduce or prevent metal elution, the olefin-based rubber preferably has a diene monomer content of 20% by mass or less, more preferably 10% by mass or less, still more preferably 7% by mass or less, further preferably 5% by mass or less. The diene monomer content may be 0% by mass or more.

The diene monomer content is also preferably 0% by mass (the olefin-based rubber is free from diene monomers).

The diene monomer content is measured in conformity with ASTM D6047.

In the case where the olefin-based rubber contains an ethylene unit, in order to further improve the corrosion resistance and the compression set properties and to further reduce or prevent metal elution, the ethylene content of the olefin-based rubber is preferably 30% by mass or more, more preferably 40% by mass or more, still more preferably 45% by mass or more, further preferably 50% by mass or more, further preferably 55% by mass or more, particularly preferably 60% by mass or more. The ethylene content may be 90% by mass or less, preferably 85% by mass or less, more preferably 80% by mass or less, still more preferably 75% by mass or less, particularly preferably 70% by mass or less.

The ethylene content is measured in conformity with ASTM D3900.

In order to further improve the corrosion resistance and the compression set properties and to further reduce or prevent metal elution, the olefin-based rubber preferably has a Mooney viscosity (ML₁₊₄ (100°C)) of 10 or higher, more preferably 20 or higher, still more preferably 30 or higher. The Mooney viscosity (ML₁₊₄ (100°C)) is preferably 40, more preferably 200 or lower, still more preferably 170 or lower.

The Mooney viscosity (ML₁₊₄ (125°C)) is preferably 10 or higher, more preferably 20 or higher, still more preferably 30 or higher, while it is preferably 40, more preferably 200 or lower, still more preferably 170 or lower.

The Mooney viscosity is measured in conformity with ASTM D1646.

The olefin-based rubber is normally crosslinked. Any crosslinking method may be employed. In order to further improve the corrosion resistance and the compression set properties and to further reduce or prevent metal elution, the olefin-based rubber is preferably crosslinked using at least one of a peroxide crosslinking agent or a sulfur-based crosslinking agent, more preferably crosslinked using a peroxide crosslinking agent.

Any known peroxide crosslinking agent can be used. Preferred is an organic peroxide. Examples of the organic peroxide include: diacyl peroxides such as benzoyl peroxide, dibenzoyl peroxide, and p-chlorobenzoyl peroxide; peroxyesters such as 1-butylperoxyacetate, t-butylperoxybenzoate, and t-butylperoxyphthalate; peroxyketals such as methyl ethyl ketone peroxide, 2,2-bis(t-butylperoxy)octane, 1,1-bis(t-butylperoxy)cyclohexane, 1,1-bis(t-butylperoxy)-3,3,5-trimethylcyclohexane, and 4,4-di(t-butylperoxy)-n-butylvalerate; dialkyl peroxides such as di-t-butylperoxybenzoate, 1,3-bis(1-butylperoxyisopropyl)benzene, dicumyl peroxide, t-butyl cumyl peroxide, dit-butyl peroxide, di-t-amyl peroxide, 1,3-bis(t-butylperoxyisopropyl)benzene, 2,5-dimethyl-2,5-di(t-butylperoxyl)hexane, and 2,5-dimethyl-2,5-bis(t-butylperoxy)hexane; and hydroxyperoxides such as t-butyl hydroperoxide.

Particularly preferred is an organic peroxide having a one-minute half-life temperature within the range of 130°C to 200°C. A dialkyl peroxide can be preferably used.

The sulfur-based crosslinking agent may be any known agent such as elemental sulfur and sulfur compounds.

The amount of the crosslinking agent used is preferably 0.5% by mass or more, more preferably 1.0% by mass or more, more preferably 3.0% by mass or more, while it is preferably 10% by mass or less, more preferably 8.0% by mass or less, still more preferably 6.0% by mass or less, based on the uncrosslinked olefin-based rubber.

The rubber member of the disclosure preferably further contains an olefin resin. This can further improve the corrosion resistance. Particularly when the olefin-based rubber is an ethylene-α-olefin rubber (preferably EPM), an olefin resin is preferably used together.

The olefin resin is a resin prepared by polymerizing at least one olefin. It may be a homopolymer or a copolymer.

Examples of the olefin resin include a polyethylene resin, a polypropylene resin, an amorphous cycloolefin resin, a crystalline cycloolefin resin, a polymethylpentene resin, an amorphous polystyrene resin, and a crystalline polystyrene resin. One or two or more of these can be used. From the viewpoint of corrosion resistance and dispersibility, preferred is a polyethylene resin.

Examples of the polyethylene resin include high density polyethylene (HDPE), medium density polyethylene (MDPE), low density polyethylene (LDPE), linear low density polyethylene (LLDPE), very low density polyethylene (VLDPE), ultra high molecular weight polyethylene (UHPE), and cross-linked polyethylene (PEX). From the viewpoint of corrosion resistance, preferred is at least one selected from the group consisting of high density polyethylene and ultra high molecular weight polyethylene.

The high density polyethylene preferably has a density of 0.940 g/m³ or higher, more preferably 0.945 g/m³ or higher, while preferably 0.970 g/m³ or lower, more preferably 0.965g/m³ or lower.

The density of polyethylene is measured in conformity with JIS K 7112.

The ultra high molecular weight polyethylene preferably has a weight average molecular weight of 1.0 × 10⁶ or more, more preferably 1.2 × 10⁶ or more, while preferably 7.0 × 10⁷ or less, more preferably 1.0 × 10⁷ or less, still more preferably 7.0 × 10⁶ or less.

The molecular weight of polyethylene is measured in polystyrene equivalent by gel permeation chromatography (GPC). The molecular weight of ultra high molecular weight polyethylene is measured by conversion from the intrinsic viscosity by the viscosity method.

The amount of the olefin resin is preferably 1% by mass or more, more preferably 15% by mass or more, still more preferably 30% by mass or more, further preferably 45% by mass or more, while it is preferably 60% by mass or less, more preferably 55% by mass or less, based on the olefin-based rubber.

The rubber member of the disclosure comes into contact with a corrosive substance. The rubber member may partly or entirely come into contact with a corrosive substance.

The corrosive substance may be any substance that is corrosive, and may be a substance that is corrosive to rubber, resin, metal, and the like. The corrosive substance may be liquid, solid, or gas. In order to more significantly achieve the effects of the disclosure, the corrosive substance is preferably liquid.

The corrosive substance preferably has a redox potential (vs. NHE) of -2.0 V or higher, more preferably -1.0 V or higher, still more preferably -0.5 V or higher, while preferably 3.0 V or lower, more preferably 2.5 V or lower, still more preferably 2.1 V or lower.

Examples of the corrosive substance include acidic substances, basic substances, oxidizing substances, organic solvents, and salt water.

Examples of the acidic substances include chemical solutions having a pH of 6 or less, preferably 5 or less, more preferably 4 or less. Specific examples include: acids such as sulfuric acid, hydrofluoric acid, nitric acid, phosphoric acid, and hydrochloric acid; mixtures of these acids; and mixtures of these acids and other substances (e.g., hydrogen peroxide).

Preferred among these is at least one selected from the group consisting of sulfuric acid, hydrofluoric acid, nitric acid, phosphoric acid, hydrochloric acid, a mixed acid of hydrofluoric acid and nitric acid, a mixed chemical solution of hydrogen peroxide water and hydrochloric acid, and a mixed chemical solution of hydrogen peroxide water and sulfuric acid, and more preferred is at least one selected from the group consisting of hydrofluoric acid, nitric acid, phosphoric acid, hydrochloric acid, a mixed acid of hydrofluoric acid and nitric acid, a mixed chemical solution of hydrogen peroxide water and hydrochloric acid, and a mixed chemical solution of hydrogen peroxide water and sulfuric acid.

Examples of the basic substances include chemical solutions having a pH of 8 or higher, preferably 9 or higher, more preferably 10 or higher. Specific examples include: bases such as TMAH ([(CH₃)₄N]⁺[OH]⁻), an aqueous sodium hydroxide solution, and ammonia; mixtures of these bases; and mixtures of these bases and other substances (e.g., hydrogen peroxide).

Preferred among these is at least one selected from the group consisting of TMAH ([(CH₃)₄N]⁺[OH]⁻), an aqueous sodium hydroxide solution, ammonia water, and a mixed chemical solution of hydrogen peroxide water and ammonia water.

The basic substance may also be a chemical solution having a redox potential (vs. NHE) of -2.0 to 0 V, preferably -1.0 to 0 V, more preferably -0.5 to 0 V. Specific examples include: basic substances such as TMAH ([(CH₃)₄N]⁺[OH]⁻), an aqueous sodium hydroxide solution, ammonia water, hydroxylamine, hydrazine, hydrogen water, and sodium sulfite; and mixtures of these basic substances and other substances.

Preferred among these is at least one selected from the group consisting of TMAH ([(CH₃)₄N]⁺[OH]⁻), ammonia water, and a mixed chemical solution of hydrogen peroxide water and ammonia water.

The oxidizing substance may be a chemical solution having a redox potential (vs. NHE) of 0 to 3.0 V, preferably 0.5 to 2.5 V, more preferably 1.0 to 2.1 V. Specific examples include: sulfuric acid, nitric acid, hydrochloric acid, hydrogen peroxide water; and mixtures of these oxidizing substances and other substances (e.g., hydrofluoric acid).

Preferred among these is at least one selected from the group consisting of sulfuric acid, nitric acid, hydrochloric acid, hydrogen peroxide water, a mixed acid of hydrofluoric acid and nitric acid, a mixed chemical solution of hydrogen peroxide water and hydrochloric acid, and a mixed chemical solution of hydrogen peroxide water and sulfuric acid, and more preferred is at least one selected from the group consisting of nitric acid, hydrochloric acid, a mixed acid of hydrofluoric acid and nitric acid, a mixed chemical solution of hydrogen peroxide water and hydrochloric acid, and a mixed chemical solution of hydrogen peroxide water and sulfuric acid.

Examples of the organic solvents include: esters such as methyl acetate, ethyl acetate, propyl acetate, n-butyl acetate, and tert-butyl acetate; ketones such as acetone, methyl ethyl ketone, and cyclohexanone; aliphatic hydrocarbons such as hexane, cyclohexane, octane, nonane, decane, undecane, dodecane, and mineral spirits; aromatic hydrocarbons such as benzene, toluene, xylene, naphthalene, and solvent naphtha; alcohols such as methanol, ethanol, isopropyl alcohol, tert-butanol, and ethylene glycol monoalkyl ether; cyclic ethers such as tetrahydrofuran, tetrahydropyran, and dioxane; nitriles such as acetonitrile and propionitrile; amides such as dimethyl sulfoxide, N,N-dimethylformamide, and N,N-dimethylacetamide; halogenated hydrocarbons such as dichloromethane, dichloroethane, and chloroform; and mixtures of these.

Preferred among these are alcohols, and more preferred is isopropyl alcohol.

The corrosive substance preferably includes at least one selected from the group consisting of acidic substances, basic substances, oxidizing substances, organic solvents, and salt water, more preferably at least one selected from the group consisting of acidic substances, basic substances, oxidizing substances, and organic solvents, still more preferably at least one selected from the group consisting of acidic substances and basic substances.

The corrosive substance preferably includes at least one selected from the group consisting of sulfuric acid, hydrofluoric acid, nitric acid, phosphoric acid, hydrochloric acid, a mixed acid of hydrofluoric acid and nitric acid, a mixed chemical solution of hydrogen peroxide water and hydrochloric acid, a mixed chemical solution of hydrogen peroxide water and sulfuric acid, TMAH, an aqueous sodium hydroxide solution, ammonia water, a mixed chemical solution of hydrogen peroxide water and ammonia water, isopropyl alcohol, and salt water, more preferably at least one selected from the group consisting of hydrofluoric acid, nitric acid, phosphoric acid, hydrochloric acid, a mixed acid of hydrofluoric acid and nitric acid, a mixed chemical solution of hydrogen peroxide water and hydrochloric acid, a mixed chemical solution of hydrogen peroxide water and sulfuric acid, TMAH, an aqueous sodium hydroxide solution, a mixed chemical solution of hydrogen peroxide water and ammonia water, and isopropyl alcohol, still more preferably at least one selected from the group consisting of hydrofluoric acid, hydrochloric acid, a mixed acid of hydrofluoric acid and nitric acid, a mixed chemical solution of hydrogen peroxide water and sulfuric acid, and TMAH.

The rubber member of the disclosure may consist of a portion (layer) containing the olefin-based rubber or have a portion (layer) containing the olefin-based rubber and a different portion (layer). In order to ensure corrosion resistance, the surface that comes into contact with the corrosive substance is preferably at least partly composed of a portion (layer) containing the olefin-based rubber. More preferably, the surface that comes into contact with the corrosive substance is entirely composed of a portion (layer) containing the olefin-based rubber.

The rubber member of the disclosure is for use as at least one selected from the group consisting of an architectural finishing material member, a mobility member, an aerospace member, a medical member, a semiconductor member, and an information and communication member. From the viewpoint of excellent corrosion resistance and low metal elution, the member is preferably a semiconductor member, more preferably a member for a semiconductor manufacturing-related apparatus (an article for a semiconductor manufacturing-related apparatus).

Examples of the architectural finishing material member include architectural interior finishing materials such as baseboards, ceiling materials, and plumbing materials, and architectural exterior finishing materials such as waterproof sheets, waterproofing materials, exterior wall materials, and roofing materials.

Examples of the mobility member include parts used in ferries, trains, automobiles, motorcycles, drones, robots, etc.

Examples of the aerospace member include exterior and interior materials for aircraft, rockets, etc., wire covering members, cable protection members, jet engines, cabin interior materials, and parts thereof.

Examples of the medical member include members such as tubing components, chemical containers, sterilization containers, medical tools, laboratory and analytical instruments, and packaging materials.

Examples of the semiconductor member include process materials used in semiconductor manufacturing, and parts for a semiconductor manufacturing-related apparatus.

Examples of the information and communication member include parts of apparatuses such as wireless LAN transmitting and receiving circuits, circuit boards, and parts of apparatuses for optical communication.

Examples of the member of the disclosure include containers, piping materials, nozzles, tubes, tanks, fittings, valves, pumps, housings, spin chucks, O-rings, packings, gaskets, washers, sealing materials, nuts, bolts, films, bottles, wire coverings, hoses, pipes, sheets, rollers, cocks, connectors, filter housings, filter cages, flowmeters, wafer carriers, and wafer boxes.

The rubber member of the disclosure can be suitably applied to at least one selected from the group consisting of containers, piping materials, nozzles, tubes, tanks, fittings, valves, pumps, spin chucks, O-rings, packings, gaskets, washers, and sealing materials because these all require corrosion resistance. The rubber member of the disclosure can be more suitably applied to at least one selected from the group consisting of O-rings, packings, gaskets, and sealing materials, particularly suitably applied to O-rings.

The rubber member of the disclosure is suitably applicable to the piping materials, nozzles, tubes, O-rings, packings, gaskets, and sealing materials (preferably O-rings, packings, gaskets, and sealing materials, more preferably O-rings) in a semiconductor manufacturing-related apparatus.

The piping material is not limited. The inner diameter is preferably 2 mm to 400 mm, more preferably 2 mm to 100 mm, particularly preferably 2 mm to 25 mm. Examples include a robust pipe, a flexible hose that can be fitted to the installation space, and a bellows pipe that is large in diameter but can be bent. The inside of the piping material is made of a material with cleanliness (less contamination of chemical solutions by extracted ions) and chemical resistance, and may be highly polished so as not to generate dust or disturb a liquid or gas flow.

Depending on the chemical solution to be flowed, such as an organic solvent, antistatic properties may be required to prevent static electricity buildup. Conductive fillers (e.g., carbon black, carbon nanotubes) may be blended to provide antistatic properties to the extent that cleanliness is not disturbed.

The nozzle is not limited. The tip of the nozzle may be precisely machined to match the size and shape of the part. In addition, since the nozzle comes into contact with another part, a highly hard and durable material that is resistant to friction and bending can be used.

The tube is not limited. The tube diameter is preferably 2 mm to 400 mm, more preferably 2 mm to 100 mm, particularly preferably 2 mm to 25 mm. Materials having stress crack resistance, chemical resistance, excellent mechanical strength, and cleanliness (less contamination of chemical solutions by extracted ions) are used. Depending on the chemical solution to be flowed, such as an organic solvent, antistatic properties may be required to prevent static electricity buildup. Conductive fillers (e.g., carbon black, carbon nanotubes) may be blended to provide antistatic properties to the extent that cleanliness is not disturbed.

The container and the tank are not limited. They may be subjected to precision cleaning (e.g., washing with water, immersion in acetic acid, immersion in hydrochloric acid, immersion in nitric acid, wiping, washing with pure water) to remove dirt or residue. Packaging after cleaning may be carried out in a clean room or clean booth environment.

The fitting and the valve are not limited. They are required to be oil-free, particle-free, dead space-free, and external leakage-free, and have a size preferably in the range of 3.2 to 40 mm in diameter, more preferably in the range of 3.2 to 12.7 mm in diameter.

The pump is not limited. It may be required to have retractability or flexibility.

The spin chuck is not limited. It may be required to have hardness, corrosion resistance, and dimensional stability, and may be provided with electrical conductivity.

The O-ring and the sealing material are not limited. The material thereof may be required to have properties including excellent elasticity, good compression set, high abrasion resistance, excellent heat resistance, resistance to the liquid or gas to be used, and long life. In particular, an O-ring used in a semiconductor manufacturing-related apparatus is used in harsh chemical environments, such as being exposed to various plasmas, and therefore may be required to have high heat resistance, chemical resistance, and plasma resistance. The compression set at 100°C for 72 hours is preferably 25% or less, more preferably 20% or less, still more preferably 15% or less, further preferably 10% or less.

The packing and the gasket are not limited. They may be required to have good compression set, a low coefficient of friction and excellent abrasion resistance. They may also be required to have heat resistance, cold resistance, pressure resistance, and chemical resistance to prevent leakage. The compression set at 100°C for 72 hours is preferably 25% or less, more preferably 20% or less, still more preferably 15% or less, further preferably 10% or less.

The washer is not limited. It may be required to have durability, corrosion resistance, and rust resistance, assuming its use in, for example, a clean room.

The member of the disclosure can be used for the following applications, for example.

### <Architectural finishing materials>

Examples include: furniture surface materials and building interior materials for walls, ceilings, and floors;
building exterior materials such as exterior walls (sidings), fences, roofs, gates, and bargeboards;
surface decorative materials such as window frames, doors, handrails, thresholds, and lintels;
membrane materials (e.g., roofing materials, ceiling materials, exterior wall materials, interior wall materials, and covering materials) for membrane buildings (e.g., sports facilities, horticultural facilities, atriums);
board materials for outdoor use (e.g., soundproof walls, windbreak fences, wave-dissipating fences, carport roofs, shopping malls, walkway walls, and roofing materials);
architectural materials such as tent fabrics for warehouse tents, membrane materials for sunshades, partial roofing materials for daylighting, window materials as alternatives to glass, flame-retardant partition membranes, curtains, exterior wall reinforcements, waterproof membranes, smoke-control membranes, non-combustible transparent partitions, and road reinforcement materials;
weather-resistant covers such as agricultural films, various roofing materials, and side walls, and the like; and
coating materials for glass products such as non-combustible fireproof safety glass.

Among these, the member of the disclosure can be particularly suitably used in membrane materials of membrane buildings; board materials for outdoor use; architectural materials such as tent fabrics for warehouse tents, membrane materials for sunshades, partial roofing materials for daylighting, window materials as alternatives to glass, flame-retardant partition membranes, curtains, exterior wall reinforcements, waterproof membranes, smoke-control membranes, non-combustible transparent partitions, and road reinforcement materials; and weather-resistant covers such as agricultural films, various roofing materials, and side walls, because these all require corrosion resistance.

When the member of the disclosure is used for any of the above applications, from the viewpoint of corrosion resistance and weather resistance, the olefin-based rubber preferably includes at least one selected from the group consisting of ethylene-propylene-diene rubber and ethylene-propylene rubber.

### <Mobility>

Examples include: O-rings (including square O-rings), tubes, packings, valve cores, hoses, sealing materials, and diaphragms used in automotive fuel systems and peripheral devices (e.g., injector O-rings, injector packings, fuel pump O-rings, diaphragms, fuel hoses, filler hoses, and evaporative hoses) (these may be resistant to sour gasoline, alcohol-based fuels, and fuels containing gasoline additives such as methyl tert-butyl ether and amines);
hoses and sealing materials (e.g., ATF hoses) used in automotive automatic transmissions;
gaskets, shaft seals, valve stem seals, sealing materials, and hoses used in automotive engines and peripheral devices (e.g., carburetor flange gaskets, engine head gaskets, metal gaskets, crankshaft seals, camshaft seals, valve stem seals, manifold packings, oil hoses);
oxygen sensors for automotive engines;

Other automotive parts such as automotive brake hoses, air conditioner hoses, radiator hoses, radiator tanks, chemical tanks, bellows, spacers, rollers, gasoline tanks, bumpers, door trims, instrument panels, and electric wire covering materials;

O-rings (including square O-rings), tubes, packings, valve cores, hoses, sealing materials, and diaphragms used in ship fuel systems and peripheral devices; and
piping corrosion protection tapes, such as tapes to be wrapped around piping on ship decks.

Among these, the rubber member of the disclosure can be particularly suitably used in O-rings (including square O-rings), tubes, packings, hoses, and sealing materials used in automotive fuel systems and peripheral devices; hoses and sealing materials used in automotive automatic transmissions; other automotive parts such as automotive brake hoses, air conditioner hoses, radiator hoses, bellows, spacers, rollers, bumpers, door trims, and electric wire covering materials; and O-rings (including square O-rings), tubes, packings, valve cores, hoses, sealing materials, and diaphragms used in ship fuel systems and peripheral devices, because these all require corrosion resistance.

When the member of the disclosure is used for any of the above applications, from the viewpoint of corrosion resistance and oil resistance, the olefin-based rubber preferably includes at least one selected from the group consisting of ethylene-propylene-diene rubber, ethylene-propylene rubber, and butyl rubber.

### <Aerospace>

Examples include O-rings (including square O-rings), tubes, packings, valve cores, hoses, sealing materials, and diaphragms used in fuel systems of aircraft and rockets and peripheral devices thereof.

Among these, the rubber member of the disclosure can be particularly suitably used in O-rings (including square O-rings), tubes, packings, hoses, and sealing materials used in fuel systems of aircraft and rockets and peripheral devices thereof, because these all require corrosion resistance.

When the member of the disclosure is used for any of the above applications, from the viewpoint of corrosion resistance and weather resistance, the olefin-based rubber preferably includes at least one selected from the group consisting of ethylene-propylene-diene rubber and ethylene-propylene rubber.

### <Medical>

Examples include: tubing components such as medical infusion tubes, blood collection tubes, drainage tubes, catheters, catheter connectors, stents, tubes, fittings, tube connectors, valves, and filters;
liquid, powder, or solid chemical containers such as packages, bottles, bottle caps, vials, ampules, prefilled syringes, infusion bags, infusion bag connectors, sealed medicine bags, press-through packages, and eye drop containers;
sample containers such as urine collection bags, sampling test tubes for blood testing, blood collection tubes, test cells, and specimen containers;
sterile containers for medical items such as scalpels, forceps, gauze, and contact lenses;
housings for electronic devices such as medical sensors, cardiac devices, and pacemakers;
medical devices such as inhalation masks, syringes, syringe rods, injection needles, surgical trays, protective caps, rubber stoppers, and endoscopes;
laboratory and analytical tools such as beakers, petri dishes, flasks, test tubes, and centrifuge tubes;
medical optical components such as plastic lenses for medical testing; and
artificial organs and their components, including denture bases, dentures, artificial hearts, dental implants, artificial bones, and artificial joints.

Among these, from the viewpoint of chemical resistance and heat resistance, the rubber member of the disclosure can be particularly suitably used in medical infusion tubes, blood collection tubes, drainage tubes, catheters, tubes, fittings, tube connectors, valves, bottles, bottle caps, vials, ampules, prefilled syringes, infusion bags, urine collection bags, sampling test tubes for blood testing, blood collection tubes, test cells, specimen containers, sterile containers, syringes, syringe rods, surgical trays, and protective caps.

When the member of the disclosure is used for any of the above applications, from the viewpoint of chemical resistance and heat resistance, the olefin-based rubber preferably includes at least one selected from the group consisting of ethylene-propylene-diene rubber and ethylene-propylene rubber.

### <Information and communications>

Examples include: insulating boards in high-frequency circuits, insulating materials for connector parts, and printed wiring boards;
bases of high-frequency vacuum tubes and antenna covers;
wire coating materials for coaxial cables and LAN cables;
coating materials for optical fibers;
displays such as liquid crystal displays; and
mobile phone components.

Among these, the rubber member of the disclosure is particularly suitably used in insulating boards in high-frequency circuits, insulating materials for connecting parts, and printed wiring boards; bases of high-frequency vacuum tubes and antenna covers; wire coating materials for coaxial cables and LAN cables; and coating materials for optical fibers, because these all require corrosion resistance.

When the member of the disclosure is used for any of the above applications, from the viewpoint of corrosion resistance, the olefin-based rubber preferably includes at least one selected from the group consisting of ethylene-propylene-diene rubber and ethylene-propylene rubber.

### <Semiconductor>

Examples include: chemical solution transfer components used in semiconductor factories and semiconductor manufacturing-related apparatuses, such as chemical tanks, containers, housings, piping materials, O-rings (including square O-rings), tubes, packings, valve cores, hoses, sealing materials, rolls, gaskets, washers, diaphragms, nozzles, fittings, coatings, and pipe linings;
Chemical stoppers and packaging films for chemicals;
waste liquid transfer components such as tanks, containers, tubes, hoses, fittings, and nozzles for waste liquid transfer;
high-temperature liquid transfer components such as containers, tubes, and hoses for high-temperature liquid transfer; and
steam piping components such as tubes and hoses for steam piping.

Among these, the rubber member of the disclosure can be particularly suitably used in O-rings (including square O-rings), tubes, packings, hoses, sealing materials, rolls, gaskets, diaphragms, and fittings used in semiconductor manufacturing-related apparatuses, because these all require corrosion resistance.

When the member of the disclosure is used for any of the above applications, the olefin-based rubber preferably includes at least one selected from the group consisting of ethylene-propylene-diene rubber and ethylene-propylene rubber.

Examples of a semiconductor manufacturing apparatus of the semiconductor manufacturing-related apparatus include photolithography process apparatuses (coating apparatuses, resist stripping apparatuses, developing apparatuses (developers), baking apparatuses, descumming apparatuses), thin film formation/etching/cleaning/drying apparatuses (vacuum deposition apparatuses, sputtering apparatuses, CVD apparatuses, cleaning apparatuses, etching apparatuses, drying apparatuses, scrub cleaning apparatuses), inspection/evaluation and manufacturing apparatuses (defect repair apparatuses), wafer processing apparatuses (wafer marking apparatuses), resist processing apparatuses (coating apparatuses, developing apparatuses, resist stripping apparatuses, ashing apparatuses, baking apparatuses), etching apparatuses (dry etching apparatuses, wet etching apparatuses), cleaning/drying apparatuses (dry cleaning apparatuses, wet cleaning apparatuses, scrub cleaning apparatuses, drying apparatuses), heat treatment apparatuses (oxidation apparatuses, diffusion apparatuses, annealing apparatuses), ion implantation apparatuses (high current ion implantation apparatuses, medium current ion implantation apparatuses, high energy ion implantation apparatuses), thin film formation apparatuses, CVD apparatuses (high-pressure CVD apparatuses, SACVD apparatuses, low-pressure CVD apparatuses, plasma CVD apparatuses, metal CVD apparatuses, ALD apparatuses), sputtering apparatuses, other thin film formation apparatuses (vacuum deposition apparatuses, silicon epitaxial growth apparatuses, compound semiconductor epitaxial apparatuses (MOCVD apparatuses, MBE apparatuses), plating apparatuses), inspection/evaluation apparatuses (Auger electron spectroscopy apparatuses), CMP apparatuses (CMP apparatuses, CMP cleaning apparatuses), other processing apparatuses (wafer marking apparatuses, back grinding machines, bump plating apparatuses, back grinder tape applicators, back grinders, back grinder tape peelers), dicing apparatuses (dicing apparatuses, wafer mounting apparatuses), bonding apparatuses (die bonding apparatuses, hybrid bonding apparatuses, wire bonding apparatuses, inner lead bonding apparatuses, outer lead bonding apparatuses, flip chip bonding apparatuses), packaging apparatuses (molding apparatuses, deburring apparatuses, solder processing apparatuses), other testing apparatuses (electron beam testing apparatuses, laser beam testing apparatuses), probing apparatuses (probers), handlers, aging apparatuses (aging apparatuses, burn-in apparatuses, IC insertion apparatuses, IC extraction apparatuses), and other inspection apparatuses (thermal test apparatuses, temperature and humidity test apparatuses, pressure cooker apparatuses, laser processing systems, various life test apparatuses). Examples of an apparatus related to a semiconductor manufacturing apparatus include various transport apparatuses (intra-process wafer transport apparatuses, inter-process wafer transport apparatuses, stockers), pure water/chemical liquid apparatuses (pure water production apparatuses, ultrafiltration apparatuses, reverse osmosis apparatuses, sterilization apparatuses, chemical supply apparatuses, slurry supply apparatuses, chemical purification apparatuses, waste liquid treatment apparatuses), various gas apparatuses (gas generation apparatuses, gas purification apparatuses, gas mixing apparatuses, gas detection apparatuses, exhaust gas treatment apparatuses), clean room apparatuses (clean benches, clean tunnels, thermal chambers, environmental test apparatuses, air showers, pass boxes), and other manufacturing-related apparatuses (various jig cleaning/drying apparatuses, flow control instruments, various taping apparatuses, various packaging apparatuses, measuring instruments for liquid/various gases).

In order to take advantage of chemical resistant properties, preferred examples of a semiconductor manufacturing apparatus in which a corrosive substance is used include, but are not limited to, photolithography process apparatuses (coating apparatuses, resist stripping apparatuses, developing apparatuses (developers), descumming apparatuses), thin film formation/etching/cleaning/drying apparatuses (vacuum deposition apparatuses, CVD apparatuses, cleaning apparatuses, etching apparatuses, drying apparatuses, scrub cleaning apparatuses), inspection/evaluation and manufacturing apparatuses (defect repair apparatuses), resist processing apparatuses (coating apparatuses, developing apparatuses, resist stripping apparatuses, ashing apparatuses), etching apparatuses (dry etching apparatuses, wet etching apparatuses), cleaning/drying apparatuses (wet cleaning apparatuses, scrub cleaning apparatuses, drying apparatuses), CVD apparatuses (high-pressure CVD apparatuses, SACVD apparatuses, low-pressure CVD apparatuses, plasma CVD apparatuses, metal CVD apparatuses, ALD apparatuses), other thin film formation apparatuses (vacuum deposition apparatuses, silicon epitaxial growth apparatuses, compound semiconductor epitaxial apparatuses (MOCVD apparatuses, MBE apparatuses), plating apparatuses), CMP apparatuses (CMP apparatuses, CMP cleaning apparatuses), and other processing apparatuses (bump plating apparatuses), aging apparatuses (aging apparatuses, burn-in apparatuses, IC insertion apparatuses, IC extraction apparatuses) and other inspection apparatuses (various life test apparatuses).

Preferred examples of an apparatus related to a semiconductor manufacturing apparatus include pure water/chemical liquid apparatuses (chemical supply apparatuses, slurry supply apparatuses, chemical purification apparatuses, waste liquid treatment apparatuses), various gas apparatuses (gas generation apparatuses, gas purification apparatuses, gas mixing apparatuses, gas detection apparatuses, exhaust gas treatment apparatuses), clean room apparatuses (thermal chambers, environmental test apparatuses), and other manufacturing-related apparatuses (various jig cleaning/drying apparatuses, flow control instruments, various packaging apparatuses, measuring instruments for liquid/various gases).

As described above, the rubber member of the disclosure can be suitably used as a member for a semiconductor manufacturing-related apparatus (an article for a semiconductor manufacturing-related apparatus). Owing to its excellent chemical resistance, the rubber member of the disclosure is more suitably used as a member constituting a semiconductor manufacturing-related apparatus in which a chemical is used, particularly as a member that comes into contact with a chemical.

The chemical is not limited. Examples thereof include chemicals used in semiconductor manufacturing-related apparatuses. One chemical may be used alone or two or more chemicals may be used in combination.

Specific examples of the chemical include at least one selected from the group consisting of TMAH ([(CH₃)₄N]⁺[OH]⁻), sulfuric acid, an aqueous sodium hydroxide solution, isopropyl alcohol, hydrofluoric acid, a mixed acid of hydrofluoric acid and nitric acid, a sulfuric acid hydrogen peroxide mixture (SPM), SC1 (a mixture of NH₄OH, H₂O₂, and H₂O), SC2 (a mixture of HCl, H₂O₂, and H₂O), phosphoric acid, and hydrochloric acid. Preferred among these are TMAH, isopropyl alcohol, hydrofluoric acid, a mixed acid of hydrofluoric acid and nitric acid, SPM, SC1, SC2, phosphoric acid, and hydrochloric acid. More preferred are TMAH, hydrofluoric acid, a mixed acid of hydrofluoric acid and nitric acid, and SPM.

The chemical may also include at least one selected from the group consisting of silicon-based gases, arsenic-based gases, phosphorus-based gases, boron-based gases, metal hydride gases, metal alkyl gases, halogenated hydrocarbon gases, halogen-halide gases, nitrogen oxide gases, hydrogen sulfide gas, ammonia gas, trimethylamine gas, propane gas, trimethylaluminum gas, hydrogen gas, helium gas, nitrogen gas, oxygen gas, argon gas, and carbon dioxide gas. The chemical may also preferably include at least one selected from the group consisting of silicon-based gases, arsenic-based gases, phosphorus-based gases, boron-based gases, metal hydride gases, metal alkyl gases, halogenated hydrocarbon gases, halogen-halide gases, nitrogen oxide gases, hydrogen sulfide gas, ammonia gas, trimethylamine gas, propane gas, trimethylaluminum gas, hydrogen gas, helium gas, nitrogen gas, oxygen gas, argon gas, and carbon dioxide gas.

Examples of the silicon-based gases include monosilane, dichlorosilane, trichlorosilane, silicon tetrachloride, silicon tetrafluoride, and disilane.

Examples of the arsenic-based gases include arsine, arsenic (III) fluoride, arsenic (V) fluoride, arsenic (III) chloride, and arsenic (V) chloride.

Examples of the phosphorus-based gases include phosphine, phosphorus (III) fluoride, phosphorus (V) fluoride, phosphorus (III) chloride, phosphorus (V) chloride, and phosphorus oxychloride.

Examples of the boron-based gases include diborane, boron trifluoride, boron trichloride, and boron tribromide.

Examples of the metal hydride gases include hydrogen selenide, monogermane, hydrogen telluride, stibine, and tin hydride.

Examples of the metal alkyl gases include trialkylgallium and trialkylindium.

Examples of the halogenated hydrocarbon gases include tetrafluoromethane, trifluoromethane, difluoromethane, hexafluoropropane, octafluoropropane, and octafluorocyclobutane.

Examples of the halogen-halide gases include fluorine, hydrogen fluoride, chlorine, hydrogen chloride, carbon tetrachloride, hydrogen bromide, sulfur hexafluoride, nitrogen trifluoride, sulfur tetrafluoride, tungsten (VI) fluoride, molybdenum (VI) fluoride, germanium tetrachloride, tin (IV) chloride, antimony (V) chloride, tungsten (VI) chloride, and molybdenum hexachloride.

Examples of the nitrogen oxide gases include nitrogen monoxide, nitrogen dioxide, and dinitrogen monoxide.

Preferred among these are ammonia gas, nitrogen trifluoride, dinitrogen monoxide, monosilane, and octafluorocyclobutane, and more preferred are ammonia gas, nitrogen trifluoride, and dinitrogen monoxide.

The member for a semiconductor manufacturing-related apparatus (article for a semiconductor manufacturing-related apparatus) may consist of a portion (layer) containing the olefin-based rubber or have a portion (layer) containing the olefin-based rubber and a different portion (layer). In order to ensure chemical resistance, the surface that comes into contact with the chemical is preferably at least partly composed of a portion (layer) containing the olefin-based rubber. More preferably, the surface that comes into contact with the chemical is entirely composed of a portion (layer) containing the olefin-based rubber.

When a test piece (size: 10 mm × 50 mm × 2 mm) including the rubber member of the disclosure is immersed in each of four chemical solutions (1), (3), (5), and (6) described later for one week, a relative value of a mass of the test piece after the immersion, with a mass before the immersion taken as 100, is preferably 50 or more and 150 or less for all the four chemical solutions. The member satisfying this requirement has excellent corrosion resistance.

The relative value is more preferably 85 or more, still more preferably 90 or more, further preferably 95 or more, particularly preferably 98 or more, while it is more preferably 120 or less, still more preferably 115 or less, further preferably 110 or less, particularly preferably 108 or less. The relative value is ideally (most preferably) 100.

When a test piece (size: 10 mm × 50 mm × 2 mm) including the rubber member of the disclosure is immersed in each of nine chemical solutions (1) to (9) described later for one week, a relative value of a mass of the test piece after the immersion, with a mass before the immersion taken as 100, is more preferably within the above range for all the nine chemical solutions.

When a test piece (size: 10 mm × 50 mm × 2 mm) including the rubber member of the disclosure is immersed in each of nine chemical solutions (1) to (9) described later for one week and a relative value of a mass of the test piece after the immersion, with a mass before the immersion taken as 100, is measured for each chemical solution, an average of the relative values for the nine chemical solutions is preferably 80 or more and 120 or less, and a standard deviation thereof is preferably 20 or less. This can further improve the corrosion resistance.

The average of the relative values is more preferably 85 or more, still more preferably 90 or more, further preferably 95 or more, particularly preferably 97 or more, while it is more preferably 115 or less, still more preferably 110 or less, further preferably 105 or less, particularly preferably 103 or less. The average of the relative values is ideally (most preferably) 100.

The standard deviation of the relative values is more preferably 15 or less, still more preferably 10 or less, further preferably 8 or less, particularly preferably 5 or less, more particularly preferably 4.5 or less, while it may be 0 or more, 1 or more, or 3 or more. The standard deviation of the relative values is ideally (most preferably) 0.

The chemical solutions used for the immersion of the test piece are listed below:
(1) 25% by mass TMAH ([(CH₃)₄N]⁺[OH]⁻) (80°C);
(2) 100% by mass isopropyl alcohol (80°C);
(3) 49% by mass hydrofluoric acid (70°C);
(4) a mixed acid of hydrofluoric acid and nitric acid (a mixture of 49% by mass hydrofluoric acid and 69 to 71% by mass nitric acid in a volume ratio of 1:5) (20°C);
(5) a mixed acid of hydrofluoric acid and nitric acid (a mixture of 49% by mass hydrofluoric acid and 69 to 71% by mass nitric acid in a volume ratio of 1:100) (20°C);
(6) SPM (a mixture of 98% by mass sulfuric acid and 30 to 36% by mass hydrogen peroxide water in a volume ratio of 2:1) (80°C);
(7) SC1 (a mixture of 25 to 28% by mass ammonia water, 30 to 36% by mass hydrogen peroxide water, and deionized water in a volume ratio of 1:1:5) (70°C);
(8) SC2 (a mixture of 35 to 37% by mass hydrochloric acid, 30 to 36% by mass hydrogen peroxide water, and deionized water in a volume ratio of 1:1:4) (70°C); and
(9) 85% by mass phosphoric acid (80°C).

When a test piece (size: 10 mm × 50 mm × 2 mm) including the rubber member of the disclosure is immersed in 3.6% by mass hydrochloric acid at 23°C for one week, the elution amounts (based on mass) of 15 metal elements (Li, Na, Mg, Al, K, Ca, Ti, Cr, Mn, Fe, Ni, Cu, Ag, Cd, and Pb) are each preferably 30 ppb or less, more preferably 25 ppb or less, still more preferably 20 ppb or less.

When a test piece (size: 10 mm × 50 mm × 2 mm) including the rubber member of the disclosure is immersed in 3.6% by mass hydrochloric acid at 23°C for one week, the elution amount (based on mass) of Zn is preferably 150 ppb or less, more preferably 100 ppb or less, still more preferably 90 ppb or less, particularly preferably 75 ppb or less.

When a test piece (size: 10 mm × 50 mm × 2 mm) including the rubber member of the disclosure is immersed in 3.6% by mass hydrochloric acid at 23°C for one week, the elution amounts (based on mass) of 16 metal elements (Li, Na, Mg, Al, K, Ca, Ti, Cr, Mn, Fe, Ni, Cu, Zn, Ag, Cd, and Pb) are each preferably 150 ppb or less, more preferably 100 ppb or less, still more preferably 90 ppb or less.

The elution amount of each of the above elements is ideally (most preferably) 0 ppb and may be equal to or greater than the detection limit.

The rubber member of the disclosure preferably has a compression set at 100°C for 72 hours of 25% or lower, more preferably 20% or lower, still more preferably 15% or lower, further preferably 10% or lower. The lower the compression set, the better. Still, it may be 1% or higher.

The compression set is measured in conformity with the test standard for EPDM-70 under JIS B 2401 "O-rings - Part 1: O-rings".

The rubber member of the disclosure can be produced, for example, by crosslinking a rubber composition. The rubber composition is prepared by kneading an uncrosslinked olefin-based rubber, a crosslinking agent, and optional components including the olefin resin described above and different components.

Examples of the different components include known additives used in rubber compositions, such as vulcanization accelerators (e.g., zinc oxide), vulcanization accelerator aids (e.g., stearic acid), fillers, antioxidants, crosslinking aids, processing aids, acid acceptors, ultraviolet absorbers, flame retardants, colorants, foaming agents, coupling agents, dispersants, and mold release agents.

The processing aid may be, for example, a lubricant or a tackifier. Examples of lubricants include paraffin and hydrocarbon resins such as paraffin wax, microcrystalline wax, and polyethylene wax; fatty acids such as stearic acid; fatty acid amides such as stearic acid amide; fatty acid esters such as butyl stearate and ester-based waxes; higher aliphatic alcohols such as stearyl alcohol; partial esters of fatty acids and polyhydric alcohols, such as glycerol fatty acid esters; and aliphatic acid metal salts such as zinc stearate.

Examples of tackifiers include coumarone resins such as coumarone indene resin; phenol-based and terpene-based resins such as phenol formaldehyde resin, terpene phenol resin, and alkyl phenol formaldehyde resin; petroleum-based hydrocarbon resins such as synthetic polyterpene resin, aromatic hydrocarbon resin, aliphatic hydrocarbon resin, and polybutene; and rosin derivatives such as rosin esters and various esters of hydrogenated rosin.

The filler used may be one commonly used for rubber compositions, such as carbon black, silicic acid, silica, silicate salt, alumina, alumina hydrate, calcium carbonate, magnesium carbonate, barium sulfate, magnesium sulfate, clay, talc, kaolin, short fibers (e.g., synthetic fibers, glass fibers, carbon fibers), conductive oxides (e.g., zinc oxide), ferrites, metal powders, mica, graphite, molybdenum disulfide, barium titanate, and boron nitride.

Examples of colorants include: inorganic pigments such as white pigments (e.g., titanium oxide, zinc oxide, gypsum), black pigments (e.g., carbon black), red pigments, and blue pigments; organic pigments such as azo pigments and phthalocyanine pigments; and dyes.

Examples of foaming agents include: inorganic foaming agents such as sodium bicarbonate and ammonium bicarbonate; and organic foaming agents such as p,p'-oxybis(benzenesulfonylhydrazide), azodicarbonamide, and dinitrosopentamethylenetetramine.

Examples of coupling agents include: coupling agents for white fillers such as vinyltrimethoxysilane, 3-methacryloxypropyltrimethoxysilane, 3-aminopropyltrimethoxysilane, 3-mercaptopropyltrimethoxysilane, and bis(3-(triethoxysilyl)propyl)tetrasulfide; and coupling agents for carbon black such as N,N'-bis(2-methyl-2-nitropropyl)-1,6-diaminohexane.

The amount of the different component is preferably 0.1% by mass or more, more preferably 1.0% by mass or more, while it is preferably 150% by mass or less, more preferably 100% by mass or less, based on the olefin-based rubber.

According to a preferred embodiment, an antioxidant is used as the different component.

Examples of antioxidants include amine-based antioxidants and phenol-based antioxidants as primary antioxidants. One or two or more of these can be used. Examples also include sulfur-based antioxidants and phosphorus-based antioxidants as secondary antioxidants. Combination use of a primary antioxidant and a secondary antioxidant is preferred. In particular, a combination of an amine-based antioxidant and a sulfur-based antioxidant is preferred.

The amount of the antioxidant is preferably 0% by mass or more, more preferably 0.1% by mass or more, particularly preferably 0.5% by mass or more, while it is preferably 30% by mass or less, particularly preferably 10% by mass or less, based on the olefin-based rubber. Use of the antioxidant in an amount of more than 30% by mass is not preferred as it may cause blooming.

The kneading may be performed by any method, such as a known method using a closed mixer or a roll kneader. In the case where the olefin resin described above is blended, from the viewpoint of more uniform mixing, the method preferably includes a step of kneading materials at a temperature equal to or higher than the melting point of the olefin resin.

The crosslinking may be performed by any known method such as hot pressing.

The crosslinking temperature is preferably 100°C or higher, more preferably 130°C or higher, while it is preferably 250°C or lower, more preferably 200°C or lower.

The crosslinking time is preferably 5 minutes or longer, more preferably 15 minutes or longer, while it is preferably 120 minutes or shorter, more preferably 60 minutes or shorter.

The disclosure also relates to a semiconductor manufacturing-related apparatus including the above-described rubber member of the disclosure mounted thereon. Use of the member of the disclosure can provide the apparatus with excellent corrosion resistance.

The semiconductor manufacturing-related apparatus of the disclosure is preferably the one described above as the semiconductor manufacturing apparatus and related apparatus of the semiconductor manufacturing-related apparatus. Moreover, the semiconductor manufacturing-related apparatus of the disclosure preferably includes at least one selected from the group consisting of semiconductor manufacturing apparatuses and semiconductor manufacturing apparatus-related apparatuses.

The semiconductor manufacturing apparatus preferably includes at least one selected from the group consisting of a photolithography process apparatus, a thin film formation/etching/cleaning/drying apparatus, an inspection/evaluation and manufacturing apparatus, a resist processing apparatus, an etching apparatus, a cleaning/drying apparatus, a CVD apparatus, a thin film formation apparatus, a CMP apparatus, a processing apparatus, an aging apparatus, and an inspection apparatus.

The semiconductor manufacturing apparatus-related apparatus preferably includes at least one selected from the group consisting of a pure water/chemical liquid apparatus, a gas apparatus, a clean room apparatus, and a manufacturing-related apparatus.

The photolithography process apparatus preferably includes at least one selected from the group consisting of a coating apparatus, a resist stripping apparatus, a developing apparatus (developer), and a descumming apparatus.

The thin film formation/etching/cleaning/drying apparatus preferably includes at least one selected from the group consisting of a vacuum deposition apparatus, a cleaning apparatus, a drying apparatus, and a scrub cleaning apparatus.

The inspection/evaluation and manufacturing apparatus is preferably a defect repair apparatus.

The resist processing apparatus preferably includes at least one selected from the group consisting of a coating apparatus, a developing apparatus, a resist stripping apparatus, and an ashing apparatus.

The etching apparatus preferably includes at least one selected from the group consisting of a dry etching apparatus and a wet etching apparatus.

The cleaning/drying apparatus preferably includes at least one selected from the group consisting of a wet cleaning apparatus, a scrub cleaning apparatus, and a drying apparatus.

The CVD apparatus preferably includes at least one selected from the group consisting of a high-pressure CVD apparatus, a SACVD apparatus, a low-pressure CVD apparatus, a plasma CVD apparatus, a metal CVD apparatus, and an ALD apparatus.

The thin film formation apparatus preferably includes at least one selected from the group consisting of a vacuum deposition apparatus, a silicon epitaxial growth apparatus, a compound semiconductor epitaxial apparatus (MOCVD apparatus, MBE apparatus), and a plating apparatus.

The CMP apparatus preferably includes at least one selected from the group consisting of a CMP apparatus and a CMP cleaning apparatus.

The processing apparatus is preferably a bump plating apparatus.

The aging apparatus preferably includes at least one selected from the group consisting of an aging apparatus, a burn-in apparatus, an IC insertion apparatus, and an IC extraction apparatus.

The inspection apparatus is preferably a life test apparatus.

The pure water/chemical liquid apparatus preferably includes at least one selected from the group consisting of a chemical supply apparatus, a slurry supply apparatus, a chemical purification apparatus, and a waste liquid treatment apparatus.

The gas apparatus preferably includes at least one selected from the group consisting of a gas generation apparatus, a gas purification apparatus, a gas mixing apparatus, a gas detection apparatus, and an exhaust gas treatment apparatus.

The clean room apparatus preferably includes at least one selected from the group consisting of a thermal chamber and an environmental test apparatus.

The manufacturing-related apparatus preferably includes at least one selected from the group consisting of a jig cleaning/drying apparatus, a flow control instrument, a packaging apparatus, and a liquid/gas measuring instrument.

It should be appreciated that a variety of modifications and changes in the structure and other details may be made to the aforementioned embodiments without departing from the spirit and scope of the claims.

### EXAMPLES

The disclosure is described in more detail below with reference to examples, but is not limited to these examples.

Physical properties were measured by the following methods.

### <Chemical resistance (corrosion resistance) test>

The rubber sheets obtained in examples and comparative examples were each cut into a size of 10 mm × 50 mm × 2 mm, and used as a test piece.

The test piece was dried at 60°C for two hours.

After drying, the mass of the test piece before immersion was measured at room temperature (20°C).

The test piece after the measurement was immersed in each of the following chemical solutions (1) to (9) and held for one week (168 hours).

The test piece after the holding was washed with pure water, wiped to remove water droplets on the surface, and dried at 60°C for 12 hours. The mass of the test piece after the immersion was measured at room temperature (20°C).

The relative value of the mass after the immersion, with the mass before the immersion taken as 100, was calculated from the masses before and after the immersion.

The average and standard deviation of the masses (relative values) after the immersion for the nine chemical solutions (1) to (9) were determined.

### (Chemical solutions)

(1) 25% by mass TMAH ([(CH₃)₄N]⁺[OH]⁻) (80°C);
(2) 100% by mass IPA (isopropyl alcohol) (80°C);
(3) 49% by mass hydrofluoric acid (70°C);
(4) a mixed acid of hydrofluoric acid and nitric acid (a mixture of 49% by mass hydrofluoric acid and 69 to 71% by mass nitric acid in a volume ratio of 1:5) (20°C);
(5) a mixed acid of hydrofluoric acid and nitric acid (a mixture of 49% by mass hydrofluoric acid and 69 to 71% by mass nitric acid in a volume ratio of 1:100) (20°C);
(6) SPM (a mixture of 98% by mass sulfuric acid and 30 to 36% by mass hydrogen peroxide water in a volume ratio of 2:1) (80°C), redox potential (vs. NHE): 1.8 V;
(7) SC1 (a mixture of 25 to 28% by mass ammonia water, 30 to 36% by mass hydrogen peroxide water, and deionized water in a volume ratio of 1:1:5) (70°C), redox potential (vs. NHE): 1.2 V;
(8) SC2 (a mixture of 35 to 37% by mass hydrochloric acid, 30 to 36% by mass hydrogen peroxide water, and deionized water in a volume ratio of 1:1:4) (70°C), redox potential (vs. NHE): 1.6 V; and
(9) 85% by mass phosphoric acid (80°C).

### <Metal elution test>

The rubber sheets obtained in examples and comparative examples were each cut into a size of 10 mm × 50 mm × 2 mm, and used as a test piece.

As pre-cleaning, the test piece was washed by immersion in 3.6% by mass hydrochloric acid for one hour, and then washed with running pure water. Then, the test piece was immersed in 100 mL of 3.6% by mass hydrochloric acid at 23°C. After one week (168 hours) from the start of the immersion, a portion of each immersion solution was collected, and the concentrations of 16 metal elements (Li, Na, Mg, Al, K, Ca, Ti, Cr, Mn, Fe, Ni, Cu, Zn, Ag, Cd, and Pb) were measured using ICP-MSI (Agilent 8900, available from Agilent Technologies, Inc.), and the measured values were used as the metal elution amounts.

### <Compression set test>

The compression set test was carried out in conformity with the test standard for EPDM-70 under JIS B 2401 "O-rings - Part 1: O-rings".

The materials used in examples and comparative examples are listed below. (Rubber)
EPT3045: EPDM available from Mitsui Chemicals, Inc., Mooney viscosity ML₁₊₄ (100°C): 40, diene monomer content: 4.7% by mass, ethylene content: 54% by mass
EP93: EPDM available from ENEOS Materials Corporation, Mooney viscosity ML₁₊₄ (125°C): 31, diene monomer content: 2.7% by mass, ethylene content: 55% by mass
EPT0045: EPM available from Mitsui Chemicals, Inc., Mooney viscosity ML₁₊₄ (100°C): 40, ethylene content: 55% by mass
EP27: EPDM available from ENEOS Materials Corporation, Mooney viscosity ML₁₊₄ (125°C): 70, diene monomer content: 4.0% by mass, ethylene content: 56% by mass
EP57C: EPDM available from ENEOS Materials Corporation, Mooney viscosity ML₁₊₄ (125°C): 58, diene monomer content: 4.5% by mass, ethylene content: 67% by mass
Butyl 065: IIR available from Japan Butyl Co., Ltd., Mooney viscosity ML₁₊₈ (125°C): 32, diene monomer content: 1.1% by mass
Butyl 365: IIR available from Japan Butyl Co., Ltd., Mooney viscosity ML₁₊₈ (125°C): 33, diene monomer content: 2.3% by mass
Zetpol 2001L: hydrogenated nitrile rubber (HNBR) available from Zeon Corporation
KE-951-U: Silicone rubber (Q) available from Shin-Etsu Chemical Co., Ltd. (Resin)
HDPE: "NOVATEC HD HJ490" available from Japan Polyethylene Corporation, density: 0.958 g/m³
UHPE: "LUBMER L4000" available from Mitsui Chemicals, Inc., weight average molecular weight: 1.5 × 10⁶ g/mol
   (Carbon black)
Seast G-SO: product of Tokai Carbon Co., Ltd., FEF carbon black
Seast 3: product of Tokai Carbon Co., Ltd., HAF carbon black
   (Crosslinking agent)
Percumyl D-40: product of NOF Corporation, dicumyl peroxide
Peroxymon F-40: product of NOF Corporation, α,α'-bis(t-butylperoxy)diisopropylbenzene
C-8: product of Shin-Etsu Chemical Co., Ltd., 2,5-dimethyl-2,5-bis(t-butylperoxy)hexane
Sulfer: "Sulfur powder 1000 µm" available from Hosoi Chemical Industry Co., Ltd.
   (Vulcanization accelerator)
Zinc oxide No. 2: "Zinc oxide No. 2" available from Sakai Chemical Industry Co., Ltd.
   (Vulcanization accelerator aid)
Stearic acid: "Stearic acid Cherry (powder)" available from NOF Corporation (Crosslinking aid)
TAIC (triallyl isocyanurate): "TAIC" available from Mitsubishi Chemical Corporation
Nocrac CD: product of Ouchi Shinko Chemical Industrial Co., Ltd., 4,4'-bis(α,α-dimethylbenzyl)diphenylamine
Nocrac MBZ: product of Ouchi Shinko Chemical Industrial Co., Ltd., zinc salt of 2-mercaptobenzimidazole
   (Antioxidant)
ANTAGE RD: product of Kawaguchi Chemical Industry Co., Ltd., polymerized 2,4-trimethyl-1,2-dihydroquinoline (TMQ)
Nocceler TT: product of Ouchi Shinko Chemical Industrial Co., Ltd., tetramethylthiuram disulfide (TMTD)

### Examples 1 to 9 and Comparative Example 1

According to the compounding ratios shown in Tables 1 to 3, kneading (pre-kneading) by a closed mixer was performed from a predetermined starting temperature for five minutes using a Labo Plastomill Banbury mixer B-250 (available from Toyo Seiki Seisaku-sho, Ltd.). Next, kneading (final kneading) with a roll was performed at 50 ± 10°C using an electric heating type high-temperature roll machine (available from Ikeda Machinery Industry Co., Ltd.). After kneading, crosslinking was performed at 170°C for 20 minutes using an electric heat press (available from Otake Kikai Kogyo K.K.), whereby rubber sheets (rubber members) were produced.

The resulting rubber sheets were subjected to the chemical resistance test. In Examples 1 to 7, the compression set test and the metal elution test were also carried out. The results are shown in Tables 1 to 3.

### Example 10

According to the compounding ratio shown in Table 2, kneading (pre-kneading) by a closed mixer was performed from a predetermined starting temperature for five minutes using a Labo Plastomill Banbury mixer B-250 (available from Toyo Seiki Seisaku-sho, Ltd.). Next, kneading (final kneading) with a roll was performed at 50 ± 10°C using an electric heating type high-temperature roll machine (available from Ikedakikaikogyo Co., Ltd.). After kneading, crosslinking was performed at 160°C for 25 minutes using an electric heat press (available from Otake Kikai Kogyo K.K.), whereby a rubber sheet (rubber member) was produced.

The resulting rubber sheet was subjected to the chemical resistance test. The results are shown in Table 2.

### Comparative Example 2

According to the compounding ratio shown in Table 4, kneading (final kneading) with a roll was performed at 50 ± 10°C using an electric heating type high-temperature roll machine (available from Ikedakikaikogyo Co., Ltd.). After kneading, the kneaded product was pressed at 165°C for 10 minutes using an electric heat press (available from Otake Kikai Kogyo K.K.) and then secondary vulcanization was performed at 200°C for four hours, whereby a rubber sheet (rubber member) was produced.

The resulting rubber sheet was subjected to the chemical resistance test. The results are shown in Table 4.

**[Table 1]**

| EPDM-EPM | | | Example 1 | Example 2 | Example 3 | Example 4 | Example 5 | Example 6 | Example 7 | Example 8 |
|---|---|---|---|---|---|---|---|---|---|---|
| Compounding ratio (parts by mass) | Pre-kneading | EPT3045 | 100 | - | - | - | - | - | - | - |
| | | EP93 | - | 100 | - | - | - | - | - | - |
| | | EPT0045 | - | - | 100 | 100 | 100 | - | - | - |
| | | EP27 | - | - | - | - | - | 100 | - | - |
| | | EP57C | - | - | - | - | - | - | 100 | 100 |
| | | Zinc oxide No. 2 | 5 | 5 | 5 | 5 | 5 | 5 | 5 | - |
| | | Seast G-SO (FEF) | 50 | 50 | 50 | 50 | 50 | 50 | 50 | 50 |
| | | ANTAGE RD (TMQ) | 0.5 | 0.5 | 0.5 | 0.5 | 0.5 | 0.5 | 0.5 | 0.5 |
| | | HOPE | - | - | - | 50 | - | - | - | - |
| | | UHPE | - | - | - | - | 50 | - | - | - |
| | | TAIC | - | 1 | 4 | 4 | 4 | - | - | - |
| | Final kneading | Percumvl D-40 (PO) | 5 | 5 | 5 | 5 | 5 | 5 | 5 | 5 |
| | Total | | 160.5 | 161.5 | 164.5 | 214.5 | 214.5 | 160.5 | 160.5 | 155.5 |
| Kneading (pre-kneading) starting temperature | | °C | 100 | 100 | 100 | 150 | 150 | 100 | 100 | 100 |
| Rolling (final kneading) temperature | | °C | 50 ± 10 | 50 ± 10 | 50 ± 10 | 50 ± 10 | 50 ± 10 | 50 ± 10 | 50 ± 10 | 50 ± 10 |
| Chemical resistance test (Mass (relative value) after immersion with mass before immersion taken as 100) | | TMAH (25%, 80°C) | 100 | 100 | 100 | 100 | 100 | 100 | 100 | 100 |
| | | IPA (80°C) | 103 | 104 | 103 | 103 | 102 | 104 | 103 | 103 |
| | | HF (49%, 70°C) | 88 | 102 | 102 | 102 | 102 | 102 | 102 | 102 |
| | | HF/HNO₃ = 1/5 (25°C) | 113 | 113 | 114 | 107 | 106 | 111 | 111 | 109 |
| | | HF/HNO₃ = 1/100 (25°C) | 98 | 118 | 118 | 108 | 108 | 114 | 113 | 105 |
| | | SPM (80°C) | 120 | 141 | 117 | 90 | 90 | 99 | 102 | 108 |
| | | SC1 (70°C) | 100 | 101 | 100 | 100 | 100 | 100 | 100 | 100 |
| | | SC2 (70°C) | 103 | 103 | 102 | 101 | 101 | 102 | 102 | 101 |
| | | H₃PO₄ (85%, 80°C) | 100 | 100 | 100 | 100 | 100 | 100 | 100 | 100 |
| | | Average | 103 | 109 | 106 | 101 | 101 | 103 | 104 | 100 |
| | | Standard deviation | 8.8 | 12.9 | 7.2 | 4. 8 | 4.8 | 4.9 | 4.5 | 3.3 |
| Compression set test (%) | | (100°C for 72 hours) | 11 | 7 | 7 | 19 | 17 | 7 | 8 | 8 |
| Metal elution test (ppb) | | Li | < 0.1 | < 0.1 | < 0.1 | < 0.1 | < 0.1 | < 0.1 | < 0.1 | < 0.1 |
| | | Na | 0.9 | 0.7 | 0.4 | 0.3 | 0.3 | 0.4 | 0.8 | 0.1 |
| | | Mg | 0.4 | 0.2 | 0.3 | 0.2 | 0.2 | 0.2 | 0.2 | 0.1 |
| | | Al | 0.8 | 0.9 | 0.5 | 0.7 | 0.8 | 0.7 | 0.5 | 0.2 |
| | | K | 0.7 | 0.3 | 0.3 | 0.2 | 0.3 | 0.3 | 0.4 | < 0.1 |
| | | Ca | 25 | 28 | 18 | 15 | 15 | 22 | 16 | 14 |
| | | Ti | < 0.1 | < 0.1 | < 0.1 | < 0.1 | < 0.1 | < 0.1 | < 0.1 | < 0.1 |
| | | Cr | 0.4 | 0.3 | 0.3 | 0.2 | < 0.1 | 0.3 | < 0.1 | < 0.1 |
| | | Mn | < 0.1 | < 0.1 | < 0.1 | < 0.1 | < 0.1 | < 0.1 | 0.1 | < 0.1 |
| | | Fe | 9.3 | 10.5 | 9.5 | 3.8 | 3.5 | 3.7 | 13.0 | 1.7 |
| | | Ni | < 0.1 | < 0.1 | < 0.1 | < 0.1 | < 0.1 | < 0.1 | < 0.1 | < 0.1 |
| | | Cu | 1.4 | 1.0 | 1.2 | 0.4 | 0.3 | 0.3 | 1.5 | 0.1 |
| | | Zn | 110 | 95 | 86 | 73 | 71 | 90 | 75 | 0.2 |
| | | Ag | < 0.1 | < 0.1 | < 0.1 | < 0.1 | < 0.1 | < 0.1 | < 0.1 | < 0.1 |
| | | Cd | < 0.1 | < 0.1 | < 0.1 | < 0.1 | < 0.1 | < 0.1 | < 0.1 | < 0.1 |
| | | Pb | < 0.1 | < 0.1 | < 0.1 | < 0.1 | < 0.1 | < 0.1 | < 0.1 | < 0.1 |

**[Table 2]**

| IIR | | | Example 9 | Example 10 |
|---|---|---|---|---|
| Compounding ratio (parts by mass) | Pre-kneading | Butyl 065 | 100 | - |
| | | Butyl 365 | - | 100 |
| | | Zinc oxide No. 2 | 3 | 3 |
| | | Stearic acid | 1 | 1 |
| | | Seast 3 (HAF) | 50 | 50 |
| | Final kneading | Sulfur | 1.75 | 1.75 |
| | | Nocceler TT (TMTD) | 1 | 1 |
| | Total | | 156.75 | 156.75 |
| Kneading (pre-kneading) starting temperature | | °C | 50 | 50 |
| Rolling (final kneading) temperature | | °C | 50 ± 10 | 50 ± 10 |
| Chemical resistance test (Mass (relative value) after immersion with mass before immersion taken as 100) | | TMAH (25%, 80°C) | 100 | 100 |
| | | IPA (80°C) | 103 | 103 |
| | | HF (49%, 70°C) | 105 | 104 |
| | | HF/HNO₃ = 1/5 (25°C) | 105 | 106 |
| | | HF/HNO₃ = 1/100 (25°C) | 111 | 109 |
| | | SPM (80°C) | 50 | 70 |
| | | SC1 (70°C) | 108 | 106 |
| | | SC2 (70°C) | 102 | 102 |
| | | H₃PO₄ (85%, 80°C) | 99 | 100 |
| | | Average | 98 | 100 |
| | | Standard deviation | 17.3 | 10.9 |

**[Table 3]**

| HNBR (hydrogenated nitrile rubber) | | | Comparative Example 1 |
|---|---|---|---|
| Compounding ratio (parts by mass) | Pre-kneading | Zetpol 2001L | 100 |
| | | Seast G-SO | 50 |
| | | Nocrac CD | 1 |
| | | Nocrac MBZ | 1 |
| | Final kneading | Peroxymon F-40 | 8 |
| | Total | | 0 |
| Kneading (pre-kneading) starting temperature | | °C | 50 |
| Rolling (final kneading) temperature | | °C | 50 ± 10 |
| Chemical resistance test (Mass (relative value) after immersion with mass before immersion taken as 100) | | TMAH (25%, 80°C) | 99 |
| | | IPA (80°C) | 122 |
| | | HF (49%, 70°C) | 125 |
| | | HF/HNO₃ = 1/5 (25°C) | 142 |
| | | HF/HNO₃ = 1/100 (25°C) | 151 |
| | | SPM (80°C) | 0 |
| | | SC1 (70°C) | 104 |
| | | SC2 (70°C) | 104 |
| | | H₃PO₄ (85%, 80°C) | 121 |
| | | Average | 107 |
| | | Standard deviation | 41.4 |

**[Table 4]**

| Q (Silicone rubber) | | | Comparative Example 2 |
|---|---|---|---|
| Compounding ratio (parts by mass) | Final kneading | KE-951-U | 100 |
| | | C-8 | 2 |
| | Total | | 102 |
| Rolling (final kneading) temperature | | °C | 50 ± 10 |
| Chemical resistance test (Mass (relative value) after immersion with mass before immersion taken as 100) | | TMAH (25%, 80°C) | 46 |
| | | IPA (80°C) | 100 |
| | | HF (49%, 70°C) | 0 |
| | | HF/HNO₃ = 1/5 (25°C) | 0 |
| | | HF/HNO₃ = 1/100 (25°C) | 0 |
| | | SPM (80°C) | 0 |
| | | SC1 (70°C) | 102 |
| | | SC2 (70°C) | 90 |
| | | H₃PO₄ (85%, 80°C) | 89 |
| | | Average | 47 |
| | | Standard deviation | 45.1 |

The rubber members of the examples were suitable for use as members (parts) in a semiconductor manufacturing-related apparatus in which a chemical is used.

## Claims

1. A rubber member comprising an olefin-based rubber,
the rubber member including at least one selected from the group consisting of an architectural finishing material member, a mobility member, an aerospace member, a semiconductor member, and an information and communication member,
the rubber member coming into contact with a corrosive substance.

2. The rubber member according to claim 1,
wherein the olefin-based rubber includes at least one selected from the group consisting of ethylene-propylene-diene rubber, ethylene-propylene rubber, and butyl rubber.

3. The rubber member according to claim 2,
wherein the ethylene-propylene-diene rubber and the ethylene-propylene rubber each have an ethylene content of 50 to 70% by mass.

4. The rubber member according to any one of claims 1 to 3,
wherein the olefin-based rubber has a diene monomer content of 0 to 5% by mass.

5. The rubber member according to any one of claims 1 to 4,
wherein the olefin-based rubber has a Mooney viscosity (ML₁₊₄ (100°C)) of 10 to 200.

6. The rubber member according to any one of claims 1 to 5,
wherein the rubber member contains an olefin resin in an amount of 1 to 60% by mass based on the olefin-based rubber.

7. The rubber member according to any one of claims 1 to 5,
wherein the rubber member contains an olefin resin in an amount of 45 to 55% by mass based on the olefin-based rubber.

8. The rubber member according to claim 6 or 7,
wherein the olefin resin is a polyethylene resin.

9. The rubber member according to any one of claims 6 to 8,
wherein the olefin resin includes at least one selected from the group consisting of high-density polyethylene having a density of 0.94 to 0.97 g/m³ and ultra high molecular weight polyethylene having a weight average molecular weight of 1.0 × 10⁶ to 1.0 × 10⁷.

10. The rubber member according to any one of claims 1 to 9,
wherein the olefin-based rubber is crosslinked using at least one of a peroxide crosslinking agent or a sulfur-based crosslinking agent.

11. The rubber member according to any one of claims 1 to 10,
wherein the rubber member includes at least one selected from the group consisting of a container, a piping material, a nozzle, a tube, a tank, a fitting, a valve, a pump, a spin chuck, an O-ring, a packing, a gasket, a washer, and a sealing material.

12. The rubber member according to any one of claims 1 to 11,
wherein the corrosive substance has a pH of 6 or lower or 8 or higher.

13. The rubber member according to any one of claims 1 to 12,
wherein the corrosive substance has a redox potential (vs. NHE) of -2.0 to 3.0 V.

14. The rubber member according to any one of claims 1 to 13,
wherein the corrosive substance includes at least one selected from the group consisting of an acidic substance, a basic substance, an oxidizing substance, an organic solvent, and salt water.

15. The rubber member according to claim 14,
wherein the acidic substance includes at least one selected from the group consisting of sulfuric acid, hydrofluoric acid, nitric acid, phosphoric acid, hydrochloric acid, a mixed acid of hydrofluoric acid and nitric acid, a mixed chemical solution of hydrogen peroxide water and hydrochloric acid, and a mixed chemical solution of hydrogen peroxide water and sulfuric acid.

16. The rubber member according to claim 14 or 15,
wherein the basic substance includes at least one selected from the group consisting of TMAH ([(CH₃)₄N]⁺[OH]⁻), an aqueous sodium hydroxide solution, ammonia water, and a mixed chemical solution of hydrogen peroxide water and ammonia water.

17. The rubber member according to any one of claims 1 to 16,
wherein the corrosive substance includes at least one selected from the group consisting of hydrofluoric acid, nitric acid, phosphoric acid, hydrochloric acid, a mixed acid of hydrofluoric acid and nitric acid, a mixed chemical solution of hydrogen peroxide water and hydrochloric acid, a mixed chemical solution of hydrogen peroxide water and sulfuric acid, TMAH ([(CH₃)₄N]⁺[OH]⁻), an aqueous sodium hydroxide solution, a mixed chemical solution of hydrogen peroxide water and ammonia water, and isopropyl alcohol.

18. The rubber member according to any one of claims 1 to 17,
wherein the rubber member is for a semiconductor manufacturing-related apparatus.

19. The rubber member according to claim 18,
wherein the semiconductor manufacturing-related apparatus is an apparatus in which a chemical is used.

20. The rubber member according to any one of claims 1 to 19,
wherein when a test piece (size: 10 mm × 50 mm × 2 mm) including the rubber member is immersed in each of the following four chemical solutions for one week, a relative value of a mass of the test piece after the immersion, with a mass before the immersion taken as 100, is 50 or more and 150 or less for all the four chemical solutions:
(chemical solutions)
25% by mass TMAH ([(CH₃)₄N]⁺[OH]⁻) (80°C);
49% by mass hydrofluoric acid (70°C);
a mixed acid of hydrofluoric acid and nitric acid (a mixture of 49% by mass hydrofluoric acid and 69 to 71% by mass nitric acid in a volume ratio of 1:100) (20°C); and
SPM (a mixture of 98% by mass sulfuric acid and 30 to 36% by mass hydrogen peroxide water in a volume ratio of 2:1) (80°C).

21. The rubber member according to any one of claims 1 to 20,
wherein when a test piece (size: 10 mm × 50 mm × 2 mm) including the rubber member is immersed in each of the following nine chemical solutions for one week and a relative value of a mass of the test piece after the immersion, with a mass before the immersion taken as 100, is measured for each chemical solution, an average of the relative values for the nine chemical solutions is 80 or more and 120 or less, and a standard deviation thereof is 20 or less:
(chemical solutions)
25% by mass TMAH ([(CH₃)₄N]⁺[OH]⁻) (80°C);
100% by mass isopropyl alcohol (80°C);
49% by mass hydrofluoric acid (70°C);
a mixed acid of hydrofluoric acid and nitric acid (a mixture of 49% by mass hydrofluoric acid and 69 to 71% by mass nitric acid in a volume ratio of 1:5) (20°C);
a mixed acid of hydrofluoric acid and nitric acid (a mixture of 49% by mass hydrofluoric acid and 69 to 71% by mass nitric acid in a volume ratio of 1:100) (20°C);
SPM (a mixture of 98% by mass sulfuric acid and 30 to 36% by mass hydrogen peroxide water in a volume ratio of 2:1) (80°C);
SC1 (a mixture of 25 to 28% by mass ammonia water, 30 to 36% by mass hydrogen peroxide water, and deionized water in a volume ratio of 1:1:5) (70°C);
SC2 (a mixture of 35 to 37% by mass hydrochloric acid, 30 to 36% by mass hydrogen peroxide water, and deionized water in a volume ratio of 1:1:4) (70°C); and 85% by mass phosphoric acid (80°C).

22. The rubber member according to any one of claims 1 to 21,
wherein when a test piece (size: 10 mm × 50 mm × 2 mm) including the rubber member is immersed in 3.6% by mass hydrochloric acid at 23°C for one week, an elution amount of each of 15 metal elements (Li, Na, Mg, Al, K, Ca, Ti, Cr, Mn, Fe, Ni, Cu, Ag, Cd, and Pb) is 30 ppb or less.

23. The rubber member according to any one of claims 1 to 22,
wherein when a test piece (size: 10 mm × 50 mm × 2 mm) including the rubber member is immersed in 3.6% by mass hydrochloric acid at 23°C for one week, an elution amount of Zn is 150 ppb or less.

24. The rubber member according to any one of claims 1 to 23,
wherein when a test piece (size: 10 mm × 50 mm × 2 mm) including the rubber member is immersed in 3.6% by mass hydrochloric acid at 23°C for one week, an elution amount of each of 16 metal elements (Li, Na, Mg, Al, K, Ca, Ti, Cr, Mn, Fe, Ni, Cu, Zn, Ag, Cd, and Pb) is 150 ppb or less.

25. A semiconductor manufacturing-related apparatus comprising the rubber member according to any one of claims 1 to 24 mounted thereon.

26. The semiconductor manufacturing-related apparatus according to claim 25, which includes at least one selected from the group consisting of a semiconductor manufacturing apparatus and a semiconductor manufacturing apparatus-related apparatus.

27. The semiconductor manufacturing-related apparatus according to claim 26,
wherein the semiconductor manufacturing apparatus includes at least one selected from the group consisting of a photolithography process apparatus, a thin film formation/etching/cleaning/drying apparatus, an inspection/evaluation and manufacturing apparatus, a resist processing apparatus, an etching apparatus, a cleaning/drying apparatus, a CVD apparatus, a thin film formation apparatus, a CMP apparatus, a processing apparatus, an aging apparatus, and an inspection apparatus; and
the semiconductor manufacturing apparatus-related apparatus includes at least one selected from the group consisting of a pure water/chemical liquid apparatus, a gas apparatus, a clean room apparatus, and a manufacturing-related apparatus.

28. The semiconductor manufacturing-related apparatus according to claim 27,
wherein the photolithography process apparatus includes at least one selected from the group consisting of a coating apparatus, a resist stripping apparatus, a developing apparatus (developer), and a descumming apparatus;
the thin film formation/etching/cleaning/drying apparatus includes at least one selected from the group consisting of a vacuum deposition apparatus, a cleaning apparatus, a drying apparatus, and a scrub cleaning apparatus;
the inspection/evaluation and manufacturing apparatus is a defect repair apparatus,
the resist processing apparatus includes at least one selected from the group consisting of a coating apparatus, a developing apparatus, a resist stripping apparatus, and an ashing apparatus;
the etching apparatus includes at least one selected from the group consisting of a dry etching apparatus and a wet etching apparatus;
the cleaning/drying apparatus includes at least one selected from the group consisting of a wet cleaning apparatus, a scrub cleaning apparatus, and a drying apparatus;
the CVD apparatus includes at least one selected from the group consisting of a high-pressure CVD apparatus, a SACVD apparatus, a low-pressure CVD apparatus, a plasma CVD apparatus, a metal CVD apparatus, and an ALD apparatus;
the thin film formation apparatus includes at least one selected from the group consisting of a vacuum deposition apparatus, a silicon epitaxial growth apparatus, a compound semiconductor epitaxial apparatus (MOCVD apparatus, MBE apparatus), and a plating apparatus;
the CMP apparatus includes at least one selected from the group consisting of a CMP apparatus and a CMP cleaning apparatus;
the processing apparatus is a bump plating apparatus;
the aging apparatus includes at least one selected from the group consisting of an aging apparatus, a burn-in apparatus, an IC insertion apparatus, and an IC extraction apparatus;
the inspection apparatus is a life test apparatus,
the pure water/chemical liquid apparatus includes at least one selected from the group consisting of a chemical supply apparatus, a slurry supply apparatus, a chemical purification apparatus, and a waste liquid treatment apparatus;
the gas apparatus includes at least one selected from the group consisting of a gas generation apparatus, a gas purification apparatus, a gas mixing apparatus, a gas detection apparatus, and an exhaust gas treatment apparatus;
the clean room apparatus includes at least one selected from the group consisting of a thermal chamber and an environmental test apparatus; and
the manufacturing-related apparatus includes at least one selected from the group consisting of a jig cleaning/drying apparatus, a flow control instrument, a packaging apparatus, and a liquid/gas measuring instrument.
